(19) Europäisches Patentamt
European Patent Office
Office européen des brevets

(11) **EP 4 564 439 A1**

(12) **EUROPEAN PATENT APPLICATION**
published in accordance with Art. 153(4) EPC

(43) Date of publication:
**04.06.2025 Bulletin 2025/23**

(21) Application number: **23857386.9**

(22) Date of filing: **23.08.2023**

(51) International Patent Classification (IPC):
***H01L 31/048*** *(2014.01)*    ***C09D 201/00*** *(2006.01)*
***C09J 7/38*** *(2018.01)*

(52) Cooperative Patent Classification (CPC):
**C09D 201/00; C09J 7/38; H10F 19/80;** Y02E 10/50

(86) International application number:
**PCT/JP2023/030320**

(87) International publication number:
**WO 2024/043278 (29.02.2024 Gazette 2024/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.08.2022 JP 2022132638**

(71) Applicant: **Nippon Paint Automotive Coatings
Co., Ltd.
Hirakata-shi, Osaka 573-1153 (JP)**

(72) Inventors:
• **TAKAHASHI, Kazuya
Hirakata-shi, Osaka 573-1153 (JP)**
• **KITAMURA, Masahiro
Hirakata-shi, Osaka 573-1153 (JP)**
• **HOSOKAWA, Takeki
Hirakata-shi, Osaka 573-1153 (JP)**

(74) Representative: **Isarpatent
Patent- und Rechtsanwälte
Barth Hassa Peckmann & Partner mbB
Friedrichstraße 31
80801 München (DE)**

(54) **DECORATIVE LAMINATED FILM FOR SOLAR CELL MODULE**

(57) To provide a decorative film for solar cell module that has excellent design and high light transmittance, and which is excellent in performances such as weather resistance, moisture and heat resistance to protect the solar cell module. A decorative laminated film for solar cell module containing: a protective film (A); a hard coat layer (B); a decorative layer (C); a support layer (G); and an adhesive layer (F), in which a decorative laminated film (L) in a state where the protective film (A) is peeled off from the decorative laminated film for solar cell module, has a total light transmittance Tt of 50% or more and 90% or less for wavelengths of 380 nm to 810 nm, a reflectance R of 5% or more and 40% or less for wavelengths of 380 nm to 1300 nm, and in which refractive index Fa of the adhesive layer is 1.3 or more and 1.8 or less.

FIG. 2

## Description

Technical Field

The present invention relates to a decorative laminated film for solar cell module.

Background Art

In recent years, attempts to generate solar power by installing solar cells on the walls of buildings have been considered. However, conventional solar cell modules are often visible from the outside, leading to a lack of design. Therefore, if they are to be installed on the exterior walls of buildings, this point needs to be improved.

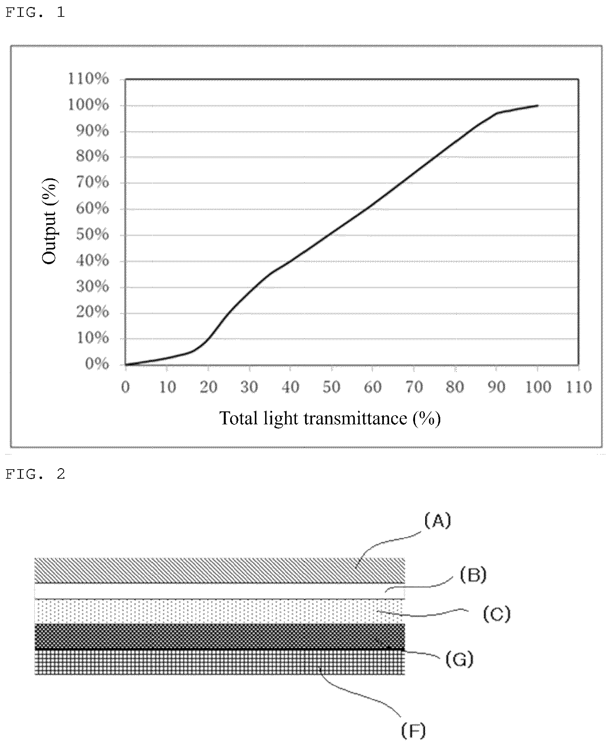

However, as shown in Figure 1, it is known that when the light transmittance of the film installed on the solar cell decreases, the output of the solar cell drops. That is, the layer with design generally absorbs and reflects visible light. As a result, when a decorative layer is provided, the light transmittance decreases, leading to a reduction in the power generation efficiency of the solar cell. Therefore, a decorative laminated film that imparts design without reducing the energy efficiency of the solar cell is required. The necessary output of a solar cell module varies depending on its use and purpose, however for example, excluding solar cell modules installed in places such as museums and art galleries, where artistic value is prioritized and the output is almost close to zero, in order to practically achieve ZEH (Zero Energy House) or ZEB (Zero Energy Building), it is necessary to secure an output of 60% or more compared to a case without decoration.

Patent Literature 1 discloses a lower layer-forming paint that contains specific components and cures by irradiation with an active energy ray to form a lower layer, which serves as the base of a hard coat layer. It also discloses a surface-coated solar cell that has a laminate composed of the lower layer obtained from the above-described paint and the hard coat layer on its surface. However, such laminate is aimed at improving weather resistance and does not exhibit high light transmittance. Moreover, since it does not contain pigments, it was not considered with the intent to impart designability.

Patent Literature 2 discloses a decorative laminated film for solar cell module that contains effect pigments and has low losses in solar cell efficiency. Patent Literatures 3 and 4 disclose decorative layers containing luster pigments with a light transmittance of 50% or more, as well as solar cell modules that include the decorative layer.

Since these decorative laminated films have high light transmittance, it can reduce solar cell output and can also impart design, however, the development of a decorative laminated film that can impart more distinctive design is still desired.

Citation List

Patent Literature

PTL 1: JP 2013-119553 A
PTL 2: WO 2019/1220793
PTL 3: JP 2021-027364 A
PTL 4: JP 2021-027266 A

Summary of Invention

Technical Problem

In view of the above, the present invention aims to provide a decorative film for solar cell module that has excellent design and high light transmittance, and which is also excellent in performances such as weather resistance, moisture and heat resistance, to protect the solar cell module

Solution to Problems

The present invention relates to a decorative laminated film for solar cell module containing:

a protective film (A);
a hard coat layer (B);
a decorative layer (C);

a support layer (G); and
an adhesive layer (F),

in which a decorative laminated film (L) in a state where the protective film (A) is peeled off from the decorative laminated film for solar cell module, has a total light transmittance Tt of 50% or more and 90% or less for wavelengths of 380 nm to 810 nm, a reflectance R of 5% or more and 40% or less for wavelengths of 380 nm to 1300 nm, and in which a refractive index Fa of the adhesive layer is 1.3 or more and 1.8 or less.

The decorative laminated film (L) in the state where the protective film (A) is peeled off from the decorative laminated film for solar cell module, preferably has an adhesive strength with the solar cell module of 1 N/25mm or more and 50 N/25mm or less.

The difference |Fa - Fg| between the refractive index Fa of the adhesive layer and the refractive index Fg of the surface of the solar cell module is preferably 0 or more and 0.5 or less.

The decorative laminated film for solar cell module can preferably be peeled off after being adhered to the solar cell module.

The hard coat layer is preferably a layer formed by a thermosetting coating composition or an active energy ray-curable coating composition.

For the decorative laminated film for solar cell module, it is preferable that the surface roughness Ra(C) of the decorative laminated film (L) from which the protective film is peeled off at a speed of 5.0 mm/s and the surface roughness Ra(P) of the peel side of the protective film satisfy the following formula (1):

$$50.0 \leq (Ra(C)/Ra(P)) \times 100 \leq 210.0 \quad (1).$$

For the decorative laminated film for solar cell module, it is preferable that the surface free energy γac of the decorative laminated film (L) in the state where the protective film is peeled off, and the surface free energy γap of the peel side of the protective film satisfy the following formula (2):

$$50.0 \leq (γac/γap) \times 100 \leq 110.0 \quad (2)$$

In addition, for the decorative laminated film for solar cell module, Martens hardness HM(L) of the decorative laminated film (L) in the state where the protective film is peeled off, preferably satisfies the following formula (3):

$$2.0 \text{ N/mm}^2 \leq HM(L) \leq 50.0 \text{ N/mm}^2 \quad (3).$$

Advantageous Effects of Invention

The decorative laminated film for solar cell module of the present invention has excellent design and also has high light transmittance. As a result, it is possible to decorate the solar cell without adversely affecting the power generation efficiency of the solar cell. Furthermore, since the film is adhered to the substrate using an adhesive layer, it can be easily peeled off when replacement is needed.

Brief Description of Drawings

FIG. 1 is a diagram showing the relationship between total light transmittance and the output of the solar cell.
FIG. 2 is a diagram showing the layer structure of the decorative film for solar cell module of the present invention.
FIG. 3 is a diagram showing the layer structure of the decorative film for solar cell module of the present invention.
FIG. 4 is a diagram showing the layer structure of the decorative film for solar cell module of the present invention.
FIG. 5 is a diagram showing the layer structure of the decorative film for solar cell module of the present invention.

Description of Embodiments

The present invention will be described in detail below.

The decorative laminated film for solar cell module of the present invention is characterized by containing a protective film (A), a hard coat layer (B), a decorative layer (C), a support layer (G), and an adhesive layer (F), in which a decorative laminated film (L) in the state where the protective film (A) is peeled off from the decorative laminated film for solar cell module, has a total light transmittance Tt of 50% or more and 90% or less for wavelengths of 380 nm to 810 nm, a reflectance R of 5% or more and 40% or less for wavelengths of 380 nm to 1300 nm, in which a refractive index Fa of the adhesive layer is 1.3 or more and 1.8 or less, and in which the decorative laminated film (L) in the state where the protective film (A) is peeled off from the decorative laminated film for solar cell module, has an adhesive strength with the solar cell module of 1N/25mm or more and 50 N/25mm or less.

The decorative laminated film for solar cell module of the present invention is characterized in that it can be adhered onto a substrate by an adhesive layer. In conventional decoration of solar cell module, it was common to either form a coating film directly on glass or to be firmly adhered onto the substrate using an adhesive.

When decoration is performed using such methods, the functionality of the decorative layer deteriorates over time, resulting in a worsening appearance, and when it becomes necessary to peel off the decorative layer and form a new one, the peeling of the aged decorative layer is not easy. In the present invention, there is an advantage in that the decorative layer can be easily peeled off in such cases.

In the decorative laminated film for solar cell module of the present invention, the refractive index Fa of the adhesive layer is set 1.3 or more and 1.8 or less. Furthermore, it is preferable to set the difference $|Fa - Fg|$ between the refractive index Fa of the adhesive layer and the refractive index Fg of the surface of the solar cell module to 0 or more and 0.5 or less.

In conventional decorative laminated films, differences of the refractive index in multiple layers could cause total reflection when light enters at a shallow angle, reducing the amount of light entering inside, which could hinder the effective use of light and result in the desired power generation efficiency not being achieved. By setting the difference in the refractive index of the adhesive layer within the above-described range, such issues are improved. In other words, reducing the reflectance increases the amount of sunlight reaching the solar cell module, which is preferable for maintaining the output of the solar cell.

The decorative laminated film for solar cell module of the present invention further contains a support layer. By containing a support layer, the strength of the laminated film is maintained, and weather resistance, workability during installation, and the like can be improved. Additionally, since the strength is retained, it has the advantage that it can be peeled off without causing breakage after being adhered to the solar cell module. In other words, it is possible to peel off the laminated film that deteriorated over time and apply a new laminated film.

Furthermore, the decorative laminated film for solar cell module of the present invention has a total light transmittance Tt of 50% or more and 90% or less for wavelengths between 380 nm and 810 nm in the state where the protective film is peeled off. By ensuring light transmittance, it is possible to achieve even better power generation efficiency and design. To ensure such high light transmittance, it is preferable to blend luster pigments into the decorative layer while enhancing the alignment of the luster pigments within the decorative layer.

As the luster pigment, generally, a plate-like pigment with a flat shape is used. By setting a state in which a luster pigment is highly aligned in a direction parallel to the surface of the film within the film layer, light scattering is controlled, and high light transmittance can be maintained.

Furthermore, when a light-interfering luster pigment is used as this luster pigment, it is possible to obtain design without impairing light transmittance while obtaining design by the light interference effect.

To ensure that such a decorative layer has high light transmittance, it is preferable that the luster pigment present in the decorative layer is highly aligned parallel to the surface direction of the coating film. To achieve such a high degree of alignment, it is preferable to use methods other than conventional film formation by typical painting techniques.

Specific methods for forming such a decorative layer will be described later.

Furthermore, the decorative laminated film for solar cell module of the present invention has a reflectance R of 5% or more and 40% or less for wavelengths ranging from 380 nm to 1300 nm in the state where the protective film is peeled off. The reflectance R is calculated from the spectral reflectance obtained within the specified wavelength range and refers to the ratio of the reflected light flux from the laminated film to the incident solar radiation on the surface of the laminated film. When the reflectance is within the above-described range, the reflected light from the laminated film becomes more easily perceptible to the human eye. In other words, while the colors and patterns applied to the laminated film are visible, the solar cell itself becomes less visible. As a result, it is assumed that a solar cell module with excellent design properties can be obtained.

The reflectance R is preferably 15% or more and 30% or less.

Note that, in the present invention, the total light transmittance Tt and reflectance R of the decorative laminated film for solar cell module refer to the values measured for the decorative laminated film (L) in the state where the protective film is peeled off.

In the present invention, the total light transmittance is the value measured by using a spectrophotometer U-4100 (Hitachi High-Technologies) in the wavelength range of 380.0 nm to 810.0 nm, using an integrating sphere. A halogen lamp was used as the light source during the measurement.

In the present invention, the reflectance is determined using a U-3310 type spectrophotometer (manufactured by Hitachi) against the aminated film which is formed, by measuring the ratio of the intensity of light used for irradiation from the light source and the intensity of light reflected by the laminated film, in the wavelength scanning mode over the range of 380 to 1300 nm under conditions of a scan speed of 300 nm/min and a sampling interval of 0.5 nm.

Hereinafter, the laminated film for decoration of solar cells of the present invention will be described in detail.

(Layer Structure)

The decorative laminated film for solar cell module of the present invention contains a protective film (A), a hard coat layer (B), a decorative layer (C), a support layer (G), and an adhesive layer (F). It is preferable that these layers are formed in the order of the protective film (A), hard coat layer (B), decorative layer (C), support layer (G), and adhesive layer (F) (see FIG. 2). By adhering a film with this configuration to the substrate, which is the solar cell, a layer is formed. Thereafter, the protective film (A) may be peeled off.

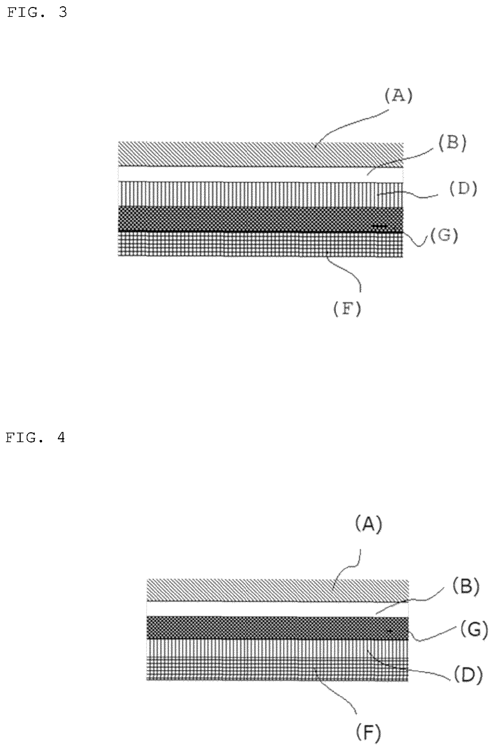

Moreover, the decorative laminated film for solar cell module of the present invention may also contain other layers such as a bonding layer and a printing layer as needed. By containing a printing layer, a good design layer can be formed through printing, which is preferable. When containing a printing layer, it can be obtained by replacing the decorative layer (C) with the printing layer. Furthermore, the printing layer may be located between the support layer (G) and the adhesive layer (F) (see FIG. 4).

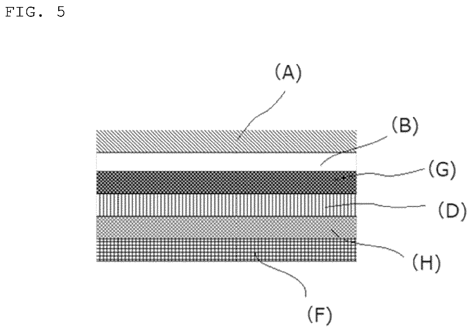

When providing the printing layer between the adhesive layer (F) and the support layer, a transparent filling layer (H) may be present to fill the printing step (see Figure 5).

Below, each layer that constitutes the laminated film for decoration of solar cells of the present invention will be described in detail.

(Decorative Layer (C))

The decorative laminated film for solar cell module of the present invention contains a decorative layer (C).

This decorative layer (C) is required to have performances such as design, light transmittance, weather resistance, and moisture and heat resistance when the solar cell module is decorated. From the viewpoint of imparting these performances, it is preferable for the layer to be formed from a thermosetting coating composition. It is preferable that the thermosetting coating composition contains a main agent and a hardener, and the main agent contains a polyol and particles of a luster pigment, and the hardener preferably contains an isocyanurate compound. The luster pigments are not particularly limited and may include, for example, metallic particles such as aluminum, chromium, gold, silver, copper, brass, titanium, nickel, nickel-chromium, stainless steel, mica, metal oxides, pearl pigments, glass flakes coated with metal or metal oxides, silica flakes coated with metal oxides, graphite, holographic pigments, and cholesteric liquid crystal polymers.

Additionally, commercially available products such as Iriodin (registered trademark), Pyrisma (registered trademark), Xirallic (registered trademark), Miraval (registered trademark), Colorstream (registered trademark), RonaStar (registered trademark), Biflair (registered trademark), and Lumina Royal (registered trademark) can also be used as luster pigments. Other commercial products such as Colorstream (registered trademark), Xirallic (registered trademark), Miraval (registered trademark), and RonaStar (registered trademark) may also be used.

As the above-described luster pigments, any one of these may be used alone, or two or more may be combined for use.

It is preferable for the luster pigment to be in the form of flaky luster pigment. More specifically, it is preferable that the dimension in the surface direction is 1 to 300 $\mu$m and that the thickness is 0.1 to 10 $\mu$m. By having such a flat shape present in the coating film in a state of high alignment, the design can be suitably exhibited.

The dimensions and thickness of the flaky luster pigment in the surface direction were measured using electron microscopy observations to calculate the surface area. The thickness was measured using a method that calculates thickness from specific gravity, weight, and surface area. The dimension in the surface direction refers to the long diameter, representing the average value of the long diameter measured from 100 particles randomly selected from the particles that appeared in the electron microscope image.

The luster pigment is preferably interference alumina flakes, interference mica flakes, glass flakes, interference silica flakes, and/or interference talc flakes. These luster pigments are preferable in that they are flaky luster pigments and can obtain design through the interference of light. Among these, interference mica flakes and glass flakes are particularly preferred.

The blending amount of luster pigment is preferably 0.1 to 60 mass% relative to the total solid content of the decorative layer. By setting the blending amount within the above range, it is possible to form a decorative layer (C) that combines design and light transmittance, and thus it is preferable. More preferably, the blending amount is 1 mass% to 50 mass%, and even more preferably 5 mass% to 30 mass%.

The thickness of the decorative layer is not particularly limited, but it is preferable to be 10 to 100 $\mu$m. More preferably, it is 5 to 70 $\mu$m, and even more preferably 10 to 50 $\mu$m.

It should be noted that in the decorative laminated film for solar cell modules of the present invention, the blending amount of the luster pigment in the decorative layer and the thickness of the decorative layer have a significant impact on light transmittance. Therefore, it is important to adjust these to achieve a predetermined light transmittance.

The decorative layer (C) can be obtained, for example, from a two-component paint composition composed of a main agent and a hardener. The curable component contained in the main agent is not particularly limited, but it is preferable to be at least one kind of polyol selected from the group consisting of acrylic polyol, polyester polyol, polyether polyol, and polycarbonate polyol. Among these, at least one selected from the group consisting of acrylic polyol, polyester polyol, and polyether polyol is particularly preferred. Additionally, the hydroxyl value of the polyol is preferably 50 mg KOH/g or more and 1000 mg KOH/g or less.

Examples of the hardener include isocyanurate compounds of hexamethylene diisocyanate trimers.

The ratio of the isocyanate group equivalent of the isocyanurate compound to the hydroxyl equivalent of the polyol (NCO/OH) is preferably 0.5/1 or more and 2/1 or less.

As the resin of the decorative layer (C), a urethane resin may be used.

The urethane resin contained in the decorative layer (C) is not particularly limited, but it is preferable for the molecular weight (Mw) of the urethane resin to be 10,000 to 200,000, and more preferably 30,000 to 150,000. When the Mw is 10,000 or more, the flexibility of the design layer increases, and when it is 200,000 or less, the production of the paint for the decorative layer (C)and the applicability to the substrate film are enhanced.

The Tg of the urethane resin is preferably -30°C to 30°C. When the Tg of the urethane resin is -30°C or higher, the tackiness (blocking) of the coating film after application and drying increases. When it is 30°C or lower, the hardness of the coating film decreases, enhancing formability and improving the physical properties of the product at low temperatures.

Furthermore, the decorative layer may contain other pigments that are not luster pigments. By containing other pigments, the design can be further enhanced. Also when these other pigments that are not luster pigments are used, it is preferable for the decorative laminated film for solar cell modules to have a total light transmittance (Tt) of 50% or more and 90% or less.

The other pigments may be added to the main agent. Examples of the other pigments include coloring pigments and extender pigments.

Examples of the coloring pigment include organic color pigments such as azo chelate pigments, insoluble azo pigments, condensed azo pigments, diketopyrrolopyrrole pigments, benzimidazolone pigments, phthalocyanine pigments, indigo pigments, perinone pigments, perylene pigments, dioxane pigments, quinacridone pigments, isoindolinone pigments, and metal complex pigments; and inorganic color pigments such as yellow lead, yellow iron oxide, red iron oxide, carbon black, and titanium dioxide. These may be used alone or in combination of two or more.

Examples of the extender pigment include calcium carbonate, barium sulfate, clay, and talc. These may be used alone or in combination of two or more. The contents of color pigments and extender pigments are not particularly limited and can be appropriately set according to the type of pigment, purpose, etc.

The decorative layer may further contain additives that are usually used in the coating and paint fields as other components. Specifically, the examples include solvents, surface conditioners, viscosity modifiers, antioxidants, defoamers, catalyst aids, anticorrosion agents, anti-settling agents, and dispersants. These additives may be added to the main agent or the hardener. The amount of additives is not particularly limited and can be set as necessary.

In the present invention, the formation of the decorative layer is preferably performed by adjusting the viscosity of the above-described paint composition within the range of 50 mPa·s to 5000 mPa·s at 25 °C and applying it with shear force.

Forming the decorative layer by such a method can achieve a higher degree of alignment for the luster pigments than when applied by conventional painting methods. This is preferable in that it allows the decorative layer (C) to maintain the total light transmittance Tt of the decorative laminated film for solar cell module at 50% or more while containing luster pigments within the range of 1 to 40 wt%.

(Protective Film (A))

There are no particular limitations on the film used to form the protective film (A). Examples include conventionally known films such as biaxially oriented polyester films, biaxially oriented polypropylene films, other biaxially oriented films, soft polyvinyl chloride films, unoriented polypropylene films, unoriented polyester films, polycarbonate films, acrylic resin films, and fluorine films. Among these, films made from polyester and/or polyolefin are preferred. Particularly, from the viewpoint of energy-saving and low-temperature processability, when no formability (stretchability) is required for application to flat substrates, biaxially oriented polyester films are more preferred, and when formability (stretchability) is required for application to three-dimensional objects, unoriented polyester films are more preferred. The thickness of the protection film (A) is preferably 0.01 to 0.5 mm, more preferably 0.02 to 0.3 mm.

The protective film (A) used in the present invention may have a surface with an uneven texture. Using such a film is preferable since the uneven texture of the protective film (A) can be transferred onto the hard coat layer (A), allowing for a matte design based on the texture. The uneven texture is not particularly limited, as long as it can be visually recognized and the matte effect for the design can be obtained.

For the decorative laminated film for solar cell module, a surface roughness Ra(C) of the decorative laminated film (L) after peeling off the protective film at a speed of 5.0 mm/sec and the surface roughness Ra (P) of the peel side of the protective film preferably satisfy the following formula (1):

$$50.0 \leq [Ra(C)/Ra(P)] \times 100 \leq 210.0 \ ...(1)$$

Satisfying formula (1) ensures the appropriate transfer of the uneven texture of the protective film (A), allowing for the desired coating film surface.

The protective film may have a release agent applied to the surface, for example, on the surface of the hard coat layer side or on the opposite side, or on both sides.

(Hard Coat Layer (B))

The decorative laminated film for solar cell module in the present invention contains a hard coat layer (B).

The hard coat layer (B) used in the present invention is preferably formed by a thermosetting coating composition or an active energy ray-curable coating composition, and its specific composition is not particularly limited as long as it does not impair the physical properties of the decorative laminated film.

Since the hard coat layer (B) forms the outermost layer when decorating the solar cell module, it requires performances such as weather resistance and moisture and heat resistance. Therefore, it is preferred that the layer is formed from a thermosetting or energy ray-curable coating composition, which is excellent in these performance aspects.

There is no particular limitation on the thermosetting coating composition and active energy-ray curable coating composition, and conventionally known compositions can be used. They may be either aqueous composition or solvent-based composition, and they may also be either single-component or two-component systems.

The above thermosetting coating compositions include, for example, two-component coating compositions containing a main agent having a polyol and a hardener having an isocyanurate compound. By mixing the main agent and the hardener, the polyol reacts with the isocyanurate compound, forming a cured coating film. The main agent and/or the hardener can be preheated and/or degassed in a vacuum before mixing. This reduces the water content in the two-component coating composition obtained by mixing both, making it easier to improve the appearance of the resulting coating film.

(Main agent)

The main agent contains polyol. Polyol is a coating film-forming resin. Polyol reacts with the hardener, for example, by heating, to form a cured coating film. Hereafter, the polyol-containing curable resins contained in the two-component coating composition may be collectively referred to as the coating film-forming resin. The main agent may also contain a curing catalyst.

The individual components are detailed below.

<Polyol>

Polyol is a coating film-forming resin. Polyol reacts with the hardener, for example, by heating, to form a cured coating film. A polyol contains two or more hydroxyl groups per molecule. This tends to increase the hardness of the resulting coating film. Polyol can be used alone or in combination of two or more types.

The main agent preferably contains a polyol (A1) with three or more hydroxyl groups per molecule and a polyol (A2) with two hydroxyl groups per molecule. There is no particular limitation on the proportion of the polyol (A1) and the polyol (A2). The proportion of polyol (A2) may be 50 mass% or less, 40 mass% or less, or 30 mass% or less of the total mass of polyol (A1) and polyol (A2).

The hydroxyl value of the polyol is preferably 50 mg KOH/g or more and 1000 mg KOH/g or less. By having the hydroxyl value of the polyol within this range, the reaction rate between the polyol and the isocyanate compound increases when the main agent and the hardener are mixed.

When two or more types of polyol are included, the apparent hydroxyl value calculated based on the hydroxyl value and mass ratio of each polyol is only required to be 100 mg KOH/g or more and 1000 mg KOH/g or less. In other words, the main agent may include a polyol with a hydroxyl value of less than 100 mg KOH/g and/or a polyol with a hydroxyl value of more than 1000 mg KOH/g.

The hydroxyl value of the polyol (including the apparent hydroxyl value, hereafter the same) is more preferably 60 mg KOH/g or more, still more preferably 100 mg KOH/g or more. The hydroxyl value of the polyol is more preferably 800 mg KOH/g or less, still more preferably 700 mg KOH/g or less.

The type of polyol is not particularly limited. Examples of polyols include polyester polyol, polyether polyol, polycarbonate polyol, polyacrylic polyol, and polyhydric alcohols. These can be used alone or in combination of two or more types. Among these, it is preferable that at least one selected from the group consisting of polyester polyol, polyacrylic polyol, and polycarbonate polyol is contained as the polyol.

The polyester polyol preferably has a branched structure. Polyester polyols having a branched structure are prepared, for example, by reacting trivalent or higher polyhydric alcohol compounds with two or more polybasic acids and repeating this reaction, as necessary.

Examples of commercially available polyester polyols include Desmophen VPLS2249/1 (manufactured by Sumika Covestro Urethane Co., Ltd.), Desmophen 800 (manufactured by Sumika Covestro Urethane Co., Ltd.), Desmophen XP2488 (manufactured by Sumika Covestro Urethane Co., Ltd.), Kuraray Polyol P-510 (manufactured by Kuraray Co., Ltd.), and Kuraray Polyol F-510 (manufactured by Kuraray Co., Ltd.).

Polyacrylic polyols are obtained by copolymerizing a polymerizable acrylic monomer having one or more hydroxyl groups in one molecule with other monomers capable of copolymerization therewith. Examples of polymerizable acrylic monomers having one or more hydroxyl groups per molecule include 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate, 2-hydroxypentyl (meth)acrylate, glycerol (meth)acrylate monoesters, trimethylolpropane (meth) acrylate monoesters, 2-hydroxy-3-chloropropyl (meth)acrylate, as well as the ring-opening polymerization adducts of, for example, (meth) acrylate esters having the above active hydrogen with lactones such as ε-caprolactone, γ-valerolactone.

Examples of other monomers capable of copolymerization with the above polymerizable acrylic monomers having one or more hydroxyl groups per molecule include (meth)acrylic acid esters such as (meth)acrylic acid, or methyl (meth)acrylate, ethyl (meth)acrylate, propyl (meth)acrylate, butyl (meth)acrylate, decyl (meth)acrylate, 2-ethylhexyl (meth)acrylate, and lauryl (meth)acrylate; styrene, or styrene derivatives such as α-methylstyrene and β-chlorostyrene; vinyl esters such as vinyl acetate, vinyl propionate, and vinyl isopropionate; and nitriles such as (meth)acrylonitrile. Additionally, polymerizable adducts obtained by the addition reaction between acrylic or methacrylic acid and monoepoxy compounds or epoxy resins can also be used.

The hydroxyl value of the acrylic polyol is preferably 2 or more.

Polycarbonate polyols can be prepared, for example, by reacting a polyhydric polyol with dimethyl carbonate.

Examples of commercially available polycarbonate polyols include Duranol T5650E (manufactured by Asahi Kasei Corporation), C-590 (manufactured by Kuraray Co., Ltd.), and ETERNACOLL PH-50 (manufactured by Ube Industries, Ltd.).

Examples of polyhydric alcohols include ethylene glycol, glycerin, trimethylolpropane, propylene glycol, tetramethylene glycol, and pentaerythritol.

The weight-average molecular weight (Mw) of the polyol is not particularly limited. The Mw of the polyol may be appropriately set according to the hydroxyl value, etc.

The main agent may contain other coating film-forming resins other than polyols. Examples of such coating film-forming resins include acrylic resins, polyester resins, alkyd resins, polyether resins, polyolefin resins, polyurethane resins, polycarbonate resins, melamine resins, epoxy resins, and carbodiimide resins. These other coating film-forming resins may be used alone or in combination of two or more.

(Curing Catalyst)

The main agent may also contain a curing catalyst. The curing catalyst is a component that promotes the curing reaction. The curing catalyst is not particularly limited, but from the viewpoint of promoting effect, at least one organic metal catalyst containing a metal element selected from the group consisting of Bi, Zn, Al, Zr, and Sn is preferred. Among these, at least one organic metal catalyst containing a metal element selected from the group consisting of Bi, Zn, Al, and Zr is preferred.

Examples of organic metal catalysts containing Bi, include bismuth carboxylate and its salts. Examples of organic metal catalysts containing Zn, include zinc complex catalysts. Examples of organic metal catalysts containing Al, include aluminum complex catalysts. Examples of organic metal catalysts containing Zr, include zirconium chelate catalysts. Examples of organic metal catalysts containing Sn, include dialkyltin dicarboxylates such as dibutyltin dilaurate, dioctyltin dilaurate, and dibutyltin diacetate; tin oxide compounds such as dibutyltin oxide; tin carboxylates such as tin 2-ethylhexanoate.

(Hardener)

The above thermosetting coating composition contains a hardener. The hardener improves the corrosion resistance and durability of the resulting coating film through a cross-linking reaction with polyols and the like.

The hardener contains isocyanurate compounds. Isocyanurate compounds are trimers of isocyanate compounds and have a cyclic structure.

The isocyanate compounds are not particularly limited and known compounds used as hardeners for two-component reactive compositions can be employed. For example, aromatic diisocyanates such as tolylene diisocyanate (TDI), 4,4'-diphenylmethane diisocyanate (MDI), xylylene diisocyanate (XDI), and meta-xylylene diisocyanate (MXDI); aliphatic diisocyanates such as hexamethylene diisocyanate (HDI), tetramethylene diisocyanate, 2-methyl-pentane-1,5-diisocyanate, 3-methyl-pentane-1,5-diisocyanate, lysine diisocyanate, and trioxyethylene diisocyanate; alicyclic diisocyanates such as isophorone diisocyanate (IPDI), cyclohexyl diisocyanate, 4,4'-dicyclohexylmethane diisocyanate, norbornane diisocyanate, hydrogenated tolylene diisocyanate, hydrogenated xylene diisocyanate, and hydrogenated tetramethylxylene diisocyanate. These can be used alone or in combination of two or more.

Among them, aliphatic diisocyanate are preferred for their relatively low viscosity, with HDI being more preferred. These isocyanate trimers exhibit particularly high reactivity with polyols.

The ratio of the isocyanate group equivalent of the isocyanate compound to the hydroxyl group equivalent of the polyol, NCO equivalent/OH equivalent, is preferably 0.5/1 or more and 2/1 or less, and more preferably 0.9/1 or more and 1.2/1 or less.

The hardener may contain other hardeners other than isocyanurate compounds. Examples of other hardeners include amino resins, monomers or dimers of the above-described isocyanate compounds, biuret derivatives of the above-mentioned isocyanate compounds, blocked derivatives of the above-mentioned isocyanate compounds, epoxy compounds, aziridine compounds, carbodiimide compounds, and oxazoline compounds. These may be used alone or in combination of two or more.

The content of the hardener is, for example, 35% by mass or more and 90% by mass or less of the resin solids in the paint composition. The above content of the hardener is preferably 45% by mass or more, more preferably 55% by mass or more. The above content of the hardener is preferably 85% by mass or less, more preferably 70% by mass or less.

(Solvent)

The content of the solvent is 30% by mass or less. According to this embodiment, even in such a high-viscosity composition with a small amount of solvent, the aggregation of luster particles is suppressed. Therefore, a coating film with a glossy appearance can be formed by in-mold coating. The content of the solvent is preferably 20% by mass or less, more preferably 10% by mass or less, and may be 0%.

The solvent is not particularly limited and is typically an organic solvent. Examples of organic solvents include ester solvents such as ethyl acetate, butyl acetate, isopropyl acetate, ethylene glycol monoethyl ether acetate, propylene glycol monomethyl ether acetate, and propylene glycol monoethyl ether acetate; ether solvents such as propylene glycol monomethyl ether, ethylene glycol monomethyl ether, methyl methoxybutanol, ethoxypropanol, ethylene glycol isopropyl ether, ethylene glycol-t-butyl ether, ethylene glycol monoethyl ether, ethylene glycol monobutyl ether, methoxybutanol, and propylene glycol monobutyl ether; alcohol solvents such as methanol, ethanol, butanol, and propyl alcohol; ketone solvents such as acetone, methyl ethyl ketone, and methyl isobutyl ketone; aliphatic hydrocarbon solvents such as Swasol, Shellsol, and mineral spirits; and aromatic solvents such as xylene, toluene, Solvesso-100 (S-100), and Solvesso-150 (S-150). These solvents can be used either alone or in combinations of two or more.

(Others)

The two-component coating composition may also contain other components as needed. These other components may be common additives used in the coating and paint fields. Specifically, examples include light stabilizers, UV absorbers, various pigments, surface conditioners, viscosity modifiers, antioxidants, UV blockers, defoamers, catalyst aids, rust inhibitors, anti-settling agents, dispersants, and more. These additives may be added to either the main agent or the hardener. The amount of additives is not particularly limited and can be adjusted appropriately as necessary.

The active energy ray-curable coating composition is a monomer, oligomer, or polymer that can crosslink and cure through exposure to radiation. As for the active energy ray-curable resin in the present invention, from the viewpoint of achieving high crosslink density after curing, improving surface hardness, and enhancing transparency, it may contain polyfunctional (meth)acrylate compounds, such as polyfunctional (meth)acrylate monomers, polyfunctional (meth)acrylate oligomers, or polyfunctional (meth) acrylate polymers. Here, "(meth)acrylate" refers to both acrylates and/or methacrylates. In this specification, the polyfunctional (meth)acrylate compounds refer to those that do not have a urethane structure and do not contain the urethane acrylates described below. The active energy ray-curable resin may also include monofunctional (meth)acrylate compounds in addition to the above-described polyfunctional (meth)acrylate compounds.

The active energy ray-curable resin that can be contained in the active energy-ray curable coating composition may, for example, contain urethane acrylate. In one aspect, the active energy ray-curable coating composition includes polyfunctional (meth)acrylate compounds and urethane acrylates.

As the urethane acrylates, urethane acrylate monomers, oligomers, polymers, or combinations of at least two of these can be used. Examples include urethane acrylates, urethane methacrylates, aliphatic urethane acrylates, aliphatic urethane methacrylates, aromatic urethane acrylates, and aromatic urethane methacrylates. Among these, polyfunctional urethane acrylate oligomers with a molecular weight of about 1000 to 10,000 are preferably used.

The active energy ray-curable coating composition in the present invention may contain polyfunctional urethane acrylates having two or more acrylate groups and ester backbones. By including this polyfunctional urethane acrylate, the resulting coating layer can exhibit sufficient adhesion to transparent polymer substrates. Additionally, the refractive index of the hard coat layer formed is within a specified range, which helps prevent interference fringes. The number of acrylate groups is 2 or more, but preferably 2 to 4. When a monofunctional urethane acrylate is used, the large molecular weight could lower reactivity, leading to reduced adhesion and hardness. When the number of functional groups is too high, there are concerns about reduced adhesion due to curing shrinkage.

A polyfunctional (meth)acrylate (compound) can be obtained, for example, by reacting a polycarbonate diol (a) (hereinafter sometimes referred to as component (a)), a (meth)acrylate compound (b) containing two hydroxyl groups and two ethylenically unsaturated groups in the molecule (hereinafter sometimes referred to as component (b)), and a polyisocyanate (c) (hereinafter sometimes referred to as component (c)).

Examples of the polycarbonate diol (a) include a diol having a straight or branched chain having 2 to 10 carbon atoms, represented by HO-(R-O-C(=O)-O)-R'OH (wherein R and R' are the same or different straight or branched alkylene groups having 2 to 10 carbon atoms, and the number of carbon atoms is the total number of carbon atoms in R and R'). Specific examples of R or R' in the above formula include ethylene group, propylene group, butylene group, pentylene group, hexylene group, heptylene group, octylene group, cyclohexylene group, neopentylene group, nonylene group, and 2-methyl-1,8-octylene group, and may be used in combination of two or more of these. Among these, polycarbonate diols synthesized from 1,5-pentanediol and/or 1,6-hexanediol are preferred. As the component (a), one type of compound may be used alone, or two or more types may be used in combination. These polyfunctional acrylates may be used alone or in mixture of two or more.

Specific examples of the (meth)acrylate compound (b) containing two hydroxyl groups and two ethylenically unsaturated groups in the molecule include a (meth)acrylic acid adduct of propylene glycol diglycidyl ether, a (meth)acrylic acid adduct of 1,6-hexanediol diglycidyl ether, a (meth)acrylic acid adduct of ethylene glycol diglycidyl ether, a (meth)acrylic acid adduct of 1,4-butanediol diglycidyl ether, a (meth)acrylic acid adduct of 1,5-pentanediol diglycidyl ether, a (meth)acrylic acid adduct of 1,7-heptanediol diglycidyl ether, a (meth)acrylic acid adduct of 1,8-octanediol diglycidyl ether. In addition, examples include a (meth)acrylic acid adduct of neopentyl glycol diglycidyl ether, a (meth)acrylic acid adduct of bisphenol A diglycidyl ether, a (meth)acrylic acid adduct of hydrogenated bisphenol A diglycidyl ether. Among these, acrylic acid adducts of propylene glycol diglycidyl ether and acrylic acid adducts of 1,6-hexanediol diglycidyl ether are preferred.

The polyisocyanate (c) is not particularly limited, but for example, aliphatic diisocyanate compounds, alicyclic diisocyanate compounds, aromatic diisocyanate compounds, and other diisocyanate compounds can be preferably used. Specifically, examples include tolylene diisocyanate, 4,4'-diphenylmethane diisocyanate, xylylene diisocyanate, xylene diisocyanate, hexamethylene diisocyanate, lysine diisocyanate, 4,4'-methylenebis(cyclohexylisocyanate), methylcyclohexane-2,4 (or 2,6)-diisocyanate, 1,3-(isocyanatemethyl)cyclohexane, isophorone diisocyanate, trimethylhexamethylene diisocyanate, dimer acid diisocyanate, dianisidine diisocyanate, phenyl diisocyanate, halogenated phenyl diisocyanate, methylene diisocyanate, ethylene diisocyanate, butylene diisocyanate, propylene diisocyanate, octadecylene diisocyanate, 1,5-naphthalene diisocyanate, polymethylene polyphenylene diisocyanate, triphenylmethane triisocyanate, naphthalene diisocyanate, tolylene diisocyanate polymer, diphenylmethane diisocyanate polymer, hexamethylene diisocyanate polymer, 3-phenyl-2-ethylene diisocyanate, cumene-2,4-diisocyanate, 4-methoxy-1,3-phenylene diisocyanate, 4-ethoxy-1,3-phenylene diisocyanate, 2,4'-diisocyanate diphenyl ether, 5,6-dimethyl-1,3-phenylene diisocyanate, 4,4'-diisocyanate diphenyl ether, benzidine diisocyanate, 9,10-anthracene diisocyanate, 4,4'-diisocyanate benzyl, 3,3'-dimethyl-4,4'-diisocyanate diphenyl methane, 2,6-dimethyl-4,4'-diisocyanate diphenyl, 3,3'-dimethoxy-4,4'-diisocyanate diphenyl, 1,4-anthracene diisocyanate, phenylene diisocyanate, 2,4,6-tolylene triisocyanate, 2,4,4'-triisocyanate diphenyl ether, 1,4-tetramethylene diisocyanate, 1,6-hexamethylene diisocyanate, 1,10-decamethylene diisocyanate, 1,3-cyclohexylene diisocyanate, and 4,4'-methylene-bis(cyclohexyl isocyanate).

As an example of the production of a polyfunctional urethane acrylate, the above-mentioned components (a) to (c) are added to an organic solvent (e.g., methyl ethyl ketone) and reacted at elevated temperature, as necessary. The end of the reaction is confirmed when the presence of isocyanate groups can no longer be confirmed by infrared absorption spectra.

The polyfunctional urethane acrylate preferably has a weight average molecular weight of 20,000 to 60,000, and more preferably has a weight average molecular weight of 30,000 to 50,000. When the weight average molecular weight of the polyfunctional urethane acrylate is too high, the viscosity increases, the smoothness is lost, and the interference fringes become worse, and when the molecular weight is too low, the viscosity decreases, the smoothness of the coating surface cannot be maintained, and the interference fringes become worse.

In addition, from the viewpoint of adhesion, the polyfunctional urethane acrylate preferably has a hydroxyl value of 0 to 20 mgKOH/g, and more preferably has a hydroxyl value of 0 to 5 mgKOH/g. By controlling the hydroxyl value to a low value, it is possible to obtain an effect of maintaining good adhesion after a wet heat test. Note that, as the polyfunctional urethane acrylate, a commercially available product may be used.

In the present invention, the active energy ray-curable resin contained in the active energy ray-curable coating composition preferably contains a polyfunctional (meth)acrylate compound and a polyfunctional urethane acrylate. In this case, the polyfunctional urethane acrylate is more preferably contained in an amount of 30 to 90 parts by mass, preferably 50 to 85 parts by mass, per 100 parts by mass of the resin component contained in the active energy ray-curable coating composition. When the amount of the polyfunctional urethane acrylate is less than 30 parts by mass, the adhesion strength decreases, and when the amount of the polyfunctional urethane acrylate is more than 90 parts by mass, the hardness of the coating layer may be impaired.

The method for synthesizing polyfunctional urethane (meth)acrylate is not particularly limited. However, for example, it can be obtained through a urethanization reaction between a polyisocyanate compound and a hydroxyl group-containing (meth)acrylate. This reaction is preferred since it is suitable for obtaining polyfunctional urethane (meth)acrylate containing three or more acrylate groups within a single molecule.

Furthermore, for the purpose of adjusting the molecular weight and molecular flexibility of polyfunctional urethane (meth)acrylate, a chain-extended urethane prepolymer with terminal isocyanate groups can be prepared by reacting a known general-purpose polyol with a polyisocyanate before reacting the polyisocyanate with the hydroxyl group-containing (meth)acrylate. This chain-extended urethane prepolymer can then be reacted with a hydroxyl group-containing (meth)acrylate to obtain the product, which may be used as component (A). The polyol is not particularly limited, but examples include ethylene oxide/propylene oxide adducts of, for example, ethylene glycol, diethylene glycol, polyethylene glycol, propylene glycol, dipropylene glycol, polypropylene glycol, neopentyl glycol, 1,4-butanediol, 1,6-hexanediol, and 3-methyl-1,5-pentanediol, polyester polyols, and copolymers of oxyethylene/oxypropylene.

The active energy-ray curable coating composition may contain, for example, hydroxyl group-containing (meth)acrylates. Examples of hydroxyl group-containing (meth)acrylates include 2-hydroxyethyl acrylate or methacrylate, 2-hydroxypropyl acrylate or methacrylate, ethylene glycol mono (meth) acrylate, propylene glycol mono(meth)acrylate, 2-hydroxy-3-methoxypropyl acrylate or methacrylate, pentaerythritol triacrylate or methacrylate, N-methylolacrylamide or methacrylamide, and N-hydroxyacrylamide or methacrylamide. Lactone adducts of these (for example, the PCL-FA or PCL-FM series produced by Daicel) can also be used.

Examples of commercially available hydroxyl group-containing (meth)acrylates include DPHA (manufactured by Daicel-Cytec Co., Ltd.), PETRA (manufactured by Daicel-Cytec Co., Ltd.: pentaerythritol triacrylate), PETIA (manufactured by Daicel-Cytec Co., Ltd.), ARONIX M-403 (manufactured by Toagosei Co., Ltd.: dipentaerythritol penta- and hexaacrylate), ARONIX M-402 (manufactured by Toagosei Co., Ltd.: dipentaerythritol penta- and hexaacrylate), ARONIX M-400 (manufactured by Toagosei Co., Ltd.: dipentaerythritol penta- and hexaacrylate), SR-399 (manufactured by Sartomer: dipentaerythritol hydroxypentaacrylate), KAYARAD DPHA (manufactured by Nippon Kayaku Co., Ltd.), and KAYARAD DPHA-2C (manufactured by Nippon Kayaku Co., Ltd.). The above products partially contain compounds that contain hydroxyl groups.

Furthermore, as commercially available polyfunctional urethane (meth)acrylates having three or more (meth)acrylate groups within a single molecule, specific product names include, bifunctional urethane (meth)acrylates ("UX-2201" or "UX-8101" manufactured by Nippon Kayaku Co., Ltd., "UF-8001", "UF-8003", "UX-6101", and "UX-8101" manufactured by Kyoeisha Chemical Co., Ltd., and "Ebecryl 244", "Ebecryl 284", "Ebecryl 2002", "Ebecryl 4835", "Ebecryl 4883", "Ebecryl 8807", and "Ebecryl 6700" manufactured by Daicel-Cytec Co., Ltd.), trifunctional urethane (meth)acrylates ("Ebecryl 254", "Ebecryl 264", "Ebecryl 265" manufactured by Daicel-Cytec Co., Ltd.), tetrafunctional urethane (meth)acrylate (Daicel-Cytec's "Ebecryl 8210"), hexafunctional urethane (meth)acrylates (Daicel-Cytec's "Ebecryl 1290k", "Ebecryl 5129", "Ebecryl 220", "KRM 8200", and "Ebecryl 1290N"), 9-functional urethane (meth)acrylate (Daicel-Cytec's "KRM 7804"), 10-functional urethane (meth)acrylates (Daicel-Cytec's "KRM 8452" and "KRM 8509"), and 15-functional urethane (meth)acrylate (Daicel-Cytec's "KRM 8655").

For example, commercially available products such as ARONIX M-400, M-450, M-305, M-309, M-310, M-315, M-320, TO-1200, TO-1231, TO-595, and TO-756 (all manufactured by Toagosei Co., Ltd.), KAYARD D-310, D-330, DPHA, and DPHA-2C (all manufactured by Nippon Kayaku Co., Ltd.), and Nikalac MX-302 (manufactured by Sanwa Chemical Co., Ltd.), which are polyfunctional (meth)acrylate compounds containing at least two (meth)acryloyl groups in the molecule, may be used.

By using the radiation curable resin containing the above-described polyfunctional (meth)acrylate compounds and polyfunctional urethane acrylates, there is an advantage of obtaining a laminated film for molding decoration that is excellent in light resistance and is not accompanied by light degradation over long-term use.

(Photopolymerization initiator)

The active energy ray-curable coating composition of the present invention preferably contains a photopolymerization initiator. The presence of the photopolymerization initiator allows the resin component to be successfully polymerized by irradiation with active energy rays such as ultraviolet rays. Examples of photopolymerization initiators include alkylphenone-based photopolymerization initiators, acylphosphine oxide-based photopolymerization initiators, titanocene-based photopolymerization initiators, and oxime ester-based polymerization initiators. Examples of alkylphenone-based photopolymerization initiators include 2,2-dimethoxy-1,2-diphenylethan-1-one, 1-hydroxy-cyclohexyl-phenyl-ketone, 2-hydroxy-2-methyl-1-phenyl-propan-1-one, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl]phenyl}-2-methyl-propan-1-one, 2-methyl-1-(4-methylthiophenyl)-2-morpholinopropan-1-one, 2-benzyl-2-dimethylamino-1-(4-morpholinophenyl)-butanone-1, 2-(dimethylamino)-2-[(4-methylphenyl)methyl]-1-[4-(4-morpholinyl)phenyl]-1-butanone. Examples of the acylphosphine oxide-based photopolymerization initiator include 2,4,6-trimethylbenzoyl-diphenyl-phosphine oxide, and bis(2,4,6-trimethylbenzoyl)-phenylphosphine oxide. Examples of the titanocene-based photopolymerization initiator include bis(η5-2,4-cyclopentadiene-1-yl)-bis(2,6-difluoro-3-(1H-pyrrol-1-yl)-phenyl) titanium, etc. Examples of oxime ester-based polymerization initiators include 1,2-octanedione, 1-[4-(phenylthio)-, 2-(O-benzoyloxime)], ethanone, 1-[9-ethyl-6-(2-methylbenzoyl)-9H-carbazol-3-yl]-, 1-(O-acetyloxime), oxyphenylacetic acid, 2-[2-oxo-2-phenylacetoxyethoxy]ethyl ester, 2-(2-hydroxyethoxy)ethyl ester, etc. These photopolymerization initiators may be used alone or in combination of two or more.

Among the above photopolymerization initiators, 2-hydroxy-2-methyl-1-phenyl-propan-1-one, 1-hydroxy-cyclohexyl-phenyl-ketone, 2-methyl-1-(4-methylthiophenyl)-2-morpholinopropan-1-one, 2-benzyl-2-dimethylamino-1-(4-morpholinophenyl)-butanone-1, 2,2-dimethoxy-1,2-diphenylethan-1-one and the like are more preferably used.

The amount of the photopolymerization initiator is preferably 0.01 to 20 parts by mass, more preferably 1 to 10 parts by mass, based on 100 parts by mass of the resin component of the active energy ray-curable coating composition. The photopolymerization initiator may be used alone or in combination of two or more kinds.

(Other components)

The active energy-ray curable coating composition may contain compounds that are usually added as paint materials as other components. Examples of other components include ultraviolet absorbers (UVA), light stabilizers (HALS), binder resins and crosslinking agents, pigments, surface conditioners, defoamers, conductive fillers, and solvents.

Furthermore, a solvent may be used to mix each of the components contained in the active energy ray curable coating composition or to adjust the viscosity. As the solvent, for example, one or two or more of conventionally known organic solvents used in paints, such as ester-based, ether-based, alcohol-based, amide-based, ketone-based, aliphatic hydrocarbon-based, alicyclic hydrocarbon-based, and aromatic hydrocarbon-based ones, may be used in combination. When using the above solvent, when a volatile substance remains in the laminated film, the volatile substance may volatilize during decoration of the substrate, causing pinholes or swelling. Therefore, it is preferable to sufficiently reduce the volatile substance contained in the laminated film.

Furthermore, the active energy ray-curable coating composition preferably further contains 0.5 to 60 parts by weight of an inorganic or organic filler having an average primary particle size of 100 nm or less. This improves blocking resistance, high scratch resistance, and surface hardness. The lower limit of the blending amount is more preferably 1% by weight, and the upper limit is more preferably 50% by weight.

Examples of the inorganic filler include silica, finely powdered glass, alumina, calcium carbonate, kaolin, clay, sepiolite (magnesium silicate), talc (magnesium silicate), mica (aluminum silicate), xonotlite (calcium silicate), aluminum borate, hydrotalcite, wollastonite (calcium silicate), potassium titanate, titanium oxide, barium sulfate, magnesium sulfate, magnesium hydroxide, yttria, ceria, silicon carbide, boron carbide, zirconia, aluminum nitride, silicon nitride, or a eutectic mixture thereof, or a nonmetallic inorganic material obtained by molding, firing, etc., so-called ceramic filler. Among these, silica, alumina, zirconia, or a eutectic mixture thereof is preferred from the viewpoint of cost and effect.

Examples of the organic filler include beads of acrylic, styrene, silicone, polyurethane, acrylic urethane, benzoguanamine, and polyethylene resins.

As commercially available products, organosilica sol MIBK-ST, MEK-ST-UP, MEK-ST-L, MEK-AC-2140Z (manufactured by Nissan Chemical Industries), SIRMIBK15ET%-H24, SIRMIBK15ET%-H83, ALMIBK30WT%-H06 (CIK Nano Tek Corporation), etc., can be used.

The active energy ray-curable coating composition may contain 0.5 to 20% by weight (the solids content ratio in the paint) of a polyisocyanate compound having isocyanate groups. The blending of polyisocyanate compounds is preferred because it imparts formability (stretchability) and scratch resistance. More preferably, the lower limit of the blending amount is 2% by weight, and the upper limit is 18% by weight.

The thickness of the hard coat layer (B) is not particularly limited, but in order to maintain performance such as surface hardness and scratch resistance, it is preferably 5 to 100 $\mu$m, more preferably 7 to 70 $\mu$m, and even more preferabl 10 to 50 $\mu$m. The viscosity of the paint, depending on the method used to form the coating film, is preferably 50 mPa·s to 5000 mPa·s, and more preferably 100 mPa·s to 3000 mPa·s. When the viscosity is lower than this range, it becomes difficult to ensure sufficient film thickness, and workability may decrease. On the other hand, when the viscosity is higher, air can remain trapped, leading to defects such as swelling during molding.

(Printing Layer (D))

The decorative laminated film for solar cell module of the present invention may have a printing layer formed by printing. Providing such a layer is preferable in that a unique appearance is obtained by the printing layer. The printing method is not particularly limited, and the layer can be formed by a known method such as inkjet printing, screen printing, offset printing, or flexographic printing. In particular, the use of inkjet printing is preferable in that various printing layers can be formed inexpensively. In addition, printing may be performed using an active energy ray-curable ink.

The curable component contained in the printing layer is not particularly limited, and for example, the polyols and urethane resins exemplified for the decorative layer (C) can be used.

The printing layer preferably contains a luster pigment as an ink pigment. As the luster pigment, for example, those listed in the decorative layer (C) can be used. By including the luster pigment, a more specific appearance is obtained and thus it is preferable. The blending amount of the luster pigment is preferably 0.1 to 60% by mass based on the total solid content of the printing layer. Setting as the above blending amount is preferable in that it is possible to form a printing layer that has both design and light transmittance. The blending amount is more preferably 1% by mass to 50% by mass, and even more preferably 5% by mass to 30% by mass.

The printing layer may further contain other pigments that are not luster pigments. By containing other pigments, the design can be further improved. As the other pigments, for example, those listed in the decorative layer (C) can be used. In addition, even when using such other pigments that are not luster pigments, the decorative laminated film for solar cell module preferably has a total light transmittance Tt of 50% or more and 90% or less.

(Transparent Filling Layer (H))

The decorative laminated film for solar cell modules of the present invention, particularly when the printed layer is placed between the support layer and the adhesive layer, preferably has a transparent filling layer formed adjacent to the printed layer.

In other words, it is a layer used to smooth out irregularities caused by printing and to ensure adhesion and smoothness of the adjacent adhesive layer. When an adhesive layer is applied over the unevenness of the printed layer, the uneven shape of the printing layer may impair the smoothness of the adhesive layer, reducing the contact area when adhered to the substrate, potentially leading to adhesion defects. The main agent contained in the transparent filling layer is not particularly limited, and for example, polyols listed for the decorative layer (C) can be used.

(Adhesive layer (F))

The decorative laminated film for solar cell module of the present invention has an adhesive layer. The adhesive layer is used to adhere the laminated film to the surface of the substrate when decorating the substrate with the laminated film. The adhesive layer provided in a normal decorative laminated film is intended to permanently adhere the substrate and the laminated film. On the other hand, since the decorative laminated film for solar cell module of the present invention is a peelable laminated film, it is preferable that the adhesive layer has an appropriate adhesive strength.

The appropriate adhesive strength of the adhesive layer can be expressed as the adhesive strength when the decorative laminated film (L), which is in the state where the protective film (A) is peeled off from the decorative laminated film for solar cell module, is peeled off from the solar cell module, the adhesive strength being in the range of 1 N/25 mm or more and 50 N/25 mm or less.

When the adhesive strength exceeds 50 N/25 mm, the adhesive strength is equivalent to that of a general adhesive layer, which leads to adhere completely to the adherend, making it difficult to peel off again. On the other hand, when the adhesive strength is less than 1 N/25 mm, the adhesive strength is insufficient and lifting is likely to occur. By having the adhesive strength within this range, application work can be easily performed without any work problems. The above adhesive strength is a value measured under the conditions described in the examples using Carboglass Polish (clear (t = 2.00 mm) manufactured by AGC Inc.)

The dry film thickness of the adhesive layer is preferably 1 to 50 $\mu$m. In order to obtain appropriate adhesiveness, it is not preferable for the film thickness to be too thick or too thin. The lower limit is more preferably 3 $\mu$m, and even more preferably 5 $\mu$m. The upper limit is more preferably 40 $\mu$m, and even more preferably 30 $\mu$m.

In one embodiment, the adhesive layer has a release film on the side opposite to the resin substrate, and the surface roughness of the release film on the adhesive layer side is 20 to 100 nm.

The adhesive contained in the adhesive layer is not particularly limited as long as it is a conventionally known adhesive, and examples thereof include Byron UR-3200 (manufactured by Toyobo Co., Ltd.), UR-1361ET (manufactured by Toagosei Co., Ltd.), and SK Dyne 1811L (manufactured by Soken Chemical & Engineering Co., Ltd.). The above adhesive may be one prepared by applying and drying the above adhesive, or may be one prepared by laminating an adhesive sheet. Various known materials can be used for the adhesive layer, but the resin is preferably an acrylic resin, a urethane resin, a polyester resin, a silicone resin, etc., and is preferably crosslinked with an isocyanate.

In the decorative laminated film for solar cell modules of the present invention, the adhesive layer has a refractive index Fa of 1.3 or more and 1.8 or less, and preferably 1.4 or more and 1.6 or less. Furthermore, the difference |Fa-Fg| with the refractive index Fg of the surface of the solar cell module which is to be coated, is preferably 0 or more and 0.5 or less, and more preferably 0 or more and 0.1 or less.

The refractive index Fa of the adhesive layer is a value measured by preparing a film containing only the adhesive layer. The refractive index Fg of the surface of the solar cell module is a value determined from the material of the substrate used, and is a value measured at d-line wavelength and room temperature (23°C). The above Fa can be adjusted to within the above range by appropriately changing the thickness, composition, etc. of the adhesive layer.

In the present invention, the refractive index is measured using an Abbe refractometer in accordance with a method conforming to JIS K0062.

The adhesive layer may contain low-refractive index particles or high-refractive index particles to adjust the refractive index to the above range.

(Low-refractive index particles)

Examples of the low-refractive index particles include hollow silica fine particles. Examples of the hollow silica fine particles include THRULYA 4320 (manufactured by JGC Catalysts and Chemicals Ltd.). Hollow acrylic fine particles may be used as the low-refractive index particles.

The content of the hollow fine silica particles is preferably 5 parts by mass or more and 90 parts by mass with respect to 100 parts by mass of the solid content of the adhesive layer. More preferably, it is 10 parts by mass to 70 parts by mass, and even more preferably, it is 15 parts by mass to 50 parts by mass.

(High-refractive index particles)

An example of the high-refractive index particles is zirconium oxide particles. An example of the zirconium oxide particles is NANON ZR-010 (manufactured by Solar Co., Ltd.). Titanium dioxide particles may be used as the high-refractive index particles.

The content of the high refractive index particles is, for example, 5 parts by mass or more and 90 parts by mass or less, based on 100 parts by mass of the solid content of the adhesive layer. More preferably, it is 10 parts by mass to 70 parts by mass, and even more preferably, it is 15 to 50 parts by mass.

(Support layer (G))

The decorative laminated film for solar cell module of the present invention has a support layer (G). As described above, since it has the support layer (G), it has the advantage that the strength of the laminated film is maintained and it can be peeled off without breaking after being attached to the solar cell module. In addition, the workability when attaching the decorative laminated film is improved. For example, it is possible to attach it manually while stretching the flexible film and applying force.

The thickness of the support layer may be adjusted appropriately, and is preferably, for example, 25 to 200 $\mu$m.

The support layer (G) may contain other components as described above. For example, when it contains an ultraviolet absorber (UVA), it is preferable because it can improve weather resistance. As the ultraviolet absorber, a benzotriazole-based one having a molecular weight of 400 or more or a triazine-based one having a molecular weight of 400 or more is preferable. Specific examples of the former include TINUVIN 234 manufactured by BASF Japan Ltd. and Adeka STAB LA-31RG manufactured by ADEKA Corporation. Specific examples of the latter include TINUVIN 1577 manufactured by BASF Japan Ltd.

As the support layer (G), conventionally known films such as thermoplastic polyurethane (TPU), biaxially oriented polyester film, biaxially oriented polypropylene film, other biaxially oriented films, soft polyvinyl chloride film, unoriented polypropylene film, unoriented polyester film, polycarbonate film, acrylic resin film, and fluorine film can be used. Among these, thermoplastic polyurethane (TPU) and soft polyvinyl chloride film are preferred because they have high conformability, flexibility, and stretchability, and can be applied to curved surfaces other than flat surfaces.

In the decorative laminate film for solar cell module of the present invention, the surface free energy γac of the decorative laminated film (L) in the state where the protective film is peeled off and the surface free energy γap of the peel side of the protective film preferably satisfy the following formula (2).

$$50.0 \leq (\gamma ac/\gamma ap) \times 100 \leq 110.0 \quad (2)$$

The lower limit of the above formula (2) is more preferably 70.0, and even more preferably 90.0. The upper limit is more preferably 105.0, and even more preferably 100.0.

The surface free energy is a value calculated from the contact angle of water and methylene iodide on the coating film surface using the Owens and Wendt formula.

Furthermore, in the decorative laminated film for solar cell module of the present invention, it is preferable that the Martens hardness HM(L) of the decorative laminated film (L) after peeling off the protective film satisfies the following formula (3).

$$2.0 \ N/mm^2 \leq HM(L) \leq 50.0 \ N/mm^2 \quad (3)$$

The Martens hardness HM(L) can be measured using a microhardness tester (model number HM2000) manufactured by Fisher Instruments Co., Ltd. This microhardness tester provides Martens hardness data calculated from a chart of indentation depth and load.

The lower limit of the above formula (3) is more preferably 5.0 N/mm$^2$, and even more preferably 10.0 N/mm$^2$.

The upper limit is more preferably 30.0 N/mm$^2$, and even more preferably 20.0 N/mm$^2$.

When the protective film of the decorative laminated film for solar cell module is peeled off at a speed of 5.0 mm/sec, this is the necessary evaluation scale for forming and maintaining the surface roughness Ra of the decorative laminated film (L). Outside the ranges of formulas (1) and (2), an appropriate surface roughness of the laminated film cannot be formed, and the design and light transmittance are reduced. Outside the range of formula (3), the surface gloss after the test is reduced in reliability in, for example, heat resistance tests.

(Method for producing decorative laminated film)

For each of layers other than the protective film (A) and support layer (G) constituting the decorative laminated film for solar cell module of the present invention, a paint composition is prepared by dissolving the components constituting the layer in a solvent, the paint compositions are applied and dried on the support layer (G), and the protective film (A) is laminated on the laminate thus formed, and thereby a laminate structure can be obtained. After that, the decorative laminated film for solar cell module of the present invention can be obtained by performing heat curing or energy ray curing.

In the decorative laminated film for solar cell module, it is important that the decorative layer (C) has a high light transmittance. To form such a decorative layer (C), it is preferable that the decorative layer (C) is formed by applying shear force and applying the coloring paint. "Applying shear force and applying coloring paint" refers to passing the paint along with the film through a gap at a certain speed, which applies shear to the paint. This causes the flaky luster pigments contained in the paint to realign, improving their alignment.

The method for applying each of the above-described layers is not particularly limited, but, for example, application can be performed using tools such as an applicator, die coater, bar coater, roll coater, comma coater, etc. After applying the paint solution with the above method, heating and drying can be performed to remove the solvent from the paint solution and form the layer.

The heating and/or irradiation with active energy ray-for curing each of the layers may be performed sequentially for each layer after the layers are formed, or the heating and/or irradiation with active energy ray may be performed after the entire laminate structure is formed.

As described above, the adhesive layer (F) may be bonded by a lamination method instead of a coating/drying method. That is, the adhesive layer (F) may be formed by preparing a film formed by the adhesive layer (F) and bonding the film by lamination on the film.

(Method of using the decorative laminated film)

The decorative film for solar cell module of the present invention can be attached to a solar cell module and used. In this case, the protective film (A) is peeled off before use.

The decorative laminated film for solar cell modules of the present invention may be attached to the light-receiving surface of a solar cell module or to the back surface. When attached to the back surface, it is preferable to make the decorative layer (C) the same color as the cell in order to improve the design.

The solar cell to which the decorative laminated film for solar cell module of the present invention can be applied is not particularly limited, and examples thereof include those using, as the photoelectric conversion layer, a polycrystalline silicon cell, a monocrystalline silicon cell, an amorphous silicon cell, a microcrystalline silicon cell, a compound solar cell such as CIGS, an organic thin film solar cell, or a dye-sensitized solar cell.

The decorative film for solar cell module of the present invention can be attached to a glass substrate or a polycarbonate substrate. The glass substrate has a flat plate shape. When the decorative film for solar cell modules of the present invention is attached thereto, it can be attached manually or by thermal lamination. In addition, the decorative laminated film may be cured with energy rays during production, or may be cured with active energy rays after attachment.

The polycarbonate substrate may be in a flat-plate shape, a curved shape, a three-dimensional shape, or the like. When attaching to a flat plate, the same method as for the glass substrate can be used.

When attaching the decorative film for solar cell module of the present invention to a polycarbonate substrate that is curved or three-dimensional, it is necessary to attach the decorative film for solar cell module while deforming it. For this reason, it is preferable to use a decorative film for solar cell module that has a certain degree of stretchability.

Specifically, for example, it is preferable not to use a biaxially oriented polyester film or a biaxially oriented polypropylene film, which can be easily applied to a flat substrate, as the support layer (G) for a substrate to which the films need to be attached while being deformed, and it is preferable to use a thermoplastic polyurethane (TPU).

The method of attaching the decorative film for solar cell module to a curved surface may be a method using a machine such as a vacuum molding machine, or may be a manual method. For example, a method may be used in which a part of the decorative film is attached to a substrate, the decorative film is stretched with one hand to fit the step or three-dimensional curved surface, and the substrate and the film are closely attached with a squeegee held in the other hand.

In addition, for substrates having a three-dimensional shape to which the films need to be attached while being deformed, it is preferable to perform curing with active energy-rays after attaching the decorative laminated film to the substrate, rather than during the preparation of the decorative laminated film. For example, a method is preferable in which the above-mentioned layers are applied and dried on the protective film (A), the adhesive layer (F) is pressed against a substrate having a three-dimensional shape to decorate it, and then irradiation with active energy rays is performed. With such a method, the uncured decorative laminated film is deformed into the shape of the substrate, and then the resin can be completely cured by energy-ray irradiation, and it can be easily deformed into the shape of the substrate.

Examples

The present invention will be explained below with reference to examples. In the examples, % in the blending ratios mean weight percent unless otherwise specified. The present invention is not limited to the examples shown below.

The compositions of each layer are as follows in Tables 1 to 3.

[Table 1]

| | | Decorative A | Decorative B | Decorative C | Decorative D | Decorative E | Decorative F |
|---|---|---|---|---|---|---|---|
| Polyol | Cortax A-200 | 90.00 | 99.9 | 60.00 | 90.00 | 99.99 | 99.99 |
| Pigments | Xirallic® T60-23 SW Galaxy Blue | 10.00 | 0.1 | 40.00 | – | 0.01 | – |
| | Cyanine Blue G314 | – | – | – | 0.50 | – | 0.01 |
| | Alpaste 93-0467 | – | – | – | 9.50 | – | – |
| Hardener | H-2550 | 10.00 | 10.00 | 10.00 | 10.00 | 10.00 | 10.00 |

Main agent: Toray Fine Chemicals Co., Ltd. product, product name "Cortax A-200", a polyacrylic polyol resin

Hardener: Nippon Paint Automotive Coatings Co., Ltd. product, product name "H2550", an isocyanate compound

Pigment: MERCK product, product name "Xirallic (registered trademark) T60-23 SW Galaxy Blue"

Pigment: Toyo Aluminium K.K. product, product name "Alpaste 93-0467"

Pigment: Cyanine Blue G314, manufactured by Sanyo Color Works Ltd.

[Table 2]

| | | HCA | HCB | HCC | HCD | HCE | HCF |
|---|---|---|---|---|---|---|---|
| Thermosetting coating composition | | | | | | | |
| Polyol | Dianal LR2731 | 67.0 | 67.0 | 67.0 | 67.0 | 70.0 | - |
| | Duranol T5650E | 30.0 | 30.0 | 30.0 | 30.0 | 30.0 | - |
| Hardener | H-2550 | 70.0 | 20.0 | 0.0 | 140. 0 | 70.0 | - |
| Others | UVA1 | 1.0 | 1.0 | 1.0 | 1.0 | - | 1.0 |
| | UVA2 | 1.0 | 1.0 | 1.0 | 1.0 | - | 1.0 |
| | HALS | 1.0 | 1.0 | 1.0 | 1.0 | - | 1.0 |
| Active energy ray-curable coating composition | | | | | | | |
| Urethane acrylate | KRM-8452 | - | - | - | - | - | 56.1 |
| Oligomer | KRM-9322 | - | - | - | - | - | 36.1 |
| Photopolymerization initiator | Omnirad 127 | - | - | - | - | - | 4.8 |

Mitsubishi Rayon Co., Ltd. product, product name "LR2731," an acrylic polyol resin
Asahi Kasei Corp. product, product name "Duranol T5650E," a polycarbonate diol
KRM-8452: Daicel-Allnex Ltd. polyfunctional urethane acrylate oligomer with a molecular weight of 3,884 and an acrylic equivalent of 120 g/eq
KRM-9322: Daicel-Allnex Ltd. polyurethane acrylate.
Hardener: Nippon Paint Automotive Coatings Co., Ltd. product, product name "H2550," an isocyanate compound.
Omnirad 127: IGM Resins product, α-hydroxyacetophenone.
UVA1: Benzotriazole-based compound.
UVA2: Triazine-based compound.
HALS: Hindered amine-based compound.

[Table 3]

|  |  | Adhesive A | Adhesive B | Adhesive C | Adhesive D | Adhesive E |
|---|---|---|---|---|---|---|
| Acrylic adhesive | SK Dyne 1811L | 100.0 | - | 50.0 | 50.0 | 40.0 |
| Silicone adhesive | KR-3704 | - | 50.0 | - | - | - |
| Silicone adhesive | KR-3700 |  | 50.0 |  |  |  |
| Refractive index adjuster | THRULYA 4320 | - | - | - | 50.0 | 60.0 |
| | NANON ZR-010 | - | - | 50.0 | - | - |
| Hardener | TD-75 | 1.0 | - | 1.0 | 1.0 | 1.0 |

Soken Chemical & Engineering Co., Ltd. product, product name "SK Dyne 1811L."
Shin-Etsu Chemical Co., Ltd. product, product name "KR-3704, KR-3700."
Solar Co., Ltd. product, product name "NANON ZR-010," zirconium oxide.
JGC Catalysts and Chemicals Ltd. product " THRULYA 4320"
Soken Chemical & Engineering Co., Ltd. product, product name "TD-75," a xylylene diisocyanate trimethylolpropane adduct.

<Production of Decorative Film>

(1) Formation of Decorative Layer

Using a Baker-type applicator, a paint solution was applied onto the support layer (substrate film) such that the dry film thickness of the decorative layer reached the specified thickness, followed by drying at 100°C for 5 minutes to obtain the decorative layer.
The support layer used was the thermoplastic polyurethane film "Esmer URS PX98" by Nihon Matai Co. Ltd.

(2) Formation of Two-Component Curing-Type Hard Coat Layer

In a same manner as the above, a two-component curing-type paint solution was applied onto the decorative layer produced in step (1) to achieve the desired dry film thickness for the hard coat layer, followed by drying at 100°C for 5 minutes. Then, using a laminating machine or the like, a protective film was adhered to the hard coat layer. After curing for 7 days at 50°C, the hard coat layer was obtained.

(3) Formation of Energy Ray-Curable Hard Coat Layer

Using a bar coater, an energy ray-curable paint solution was applied onto the decorative layer produced in step (1) to achieve the desired dry film thickness for the hard coat layer, followed by drying at 80°C for 1 minute. A protective film was then laminated onto the hard coat layer using a laminating machine or the like, and the hard coat layer was obtained by performing irradiation with energy rays with a total dose of 2000 mJ/cm$^2$.

(4)Formation of Adhesive Layer

On a surface of the substrate, the surface being different from the one on which the decorative and hard coat layers were laminated, a paint solution was applied for an adhesive layer using a Baker-type applicator such that the dry film thickness ranged from 3 to 60 μm, followed by drying at 100°C for 5 minutes, and thereby the adhesive layer was applied. Afterward, using a laminating machine or the like, a separator was laminated onto the adhesive layer, and the film was cured for 4 days at 50°C, resulting in the decorative film with an adhesive layer.
The protective films used were "Trefan #40-2500" by Toray Industries and "KB Film N30" by Kimoto Co., Ltd.

<Production of modules>

Using a glass monocrystalline silicon cell, the decorative laminated film produced by the above manufacturing method was manually applied at room temperature using a squeegee
The obtained decorative laminated film for solar cell module was evaluated on the following items:

(Total Light Transmittance (Tt))

Using a spectrophotometer U-4100 (manufactured by Hitachi High-Technologies), the total light transmittance was measured over the wavelength range of 380.0 nm to 810.0 nm using an integrating sphere.

(Reflectance R)

Using the U-3310 spectrophotometer (manufactured by Hitachi), the reflectance was measured in wavelength scan mode over the range of 380 to 1300 nm, under the conditions of a scan speed of 300 nm/min and a sampling interval of 0.5 nm.

(Refractive Indices Fa, Fg)

The refractive indices were measured using an Abbe refractometer manufactured by Atago Co., Ltd.

(Design (Reflective Color))

The decorative laminated film was applied on top of a black gel poly sheet, and the color tone after peeling off the protective film was visually inspected.

A: The color tone can be visually recognized.
C: The color tone cannot be visually recognized (the color is faint).

(Output)

For the solar cell module, irradiation with light was performed using a solar simulator ($1kW/m^2$, set to satisfy the spectral match of JIS C8912 Class A), and the output (W) was measured using the IV curve tracer MP-160 (manufactured by Eiko Seiki Co., Ltd.). The output ratio was calculated as the percentage of the output in comparison to the case without the decorative layer, which was set to 100. The evaluation was done as follows:

A: 50% or higher
C: Less than 50%.

(Adhesive Strength)

The decorative laminated film was cut into strips measuring 25mm × 200mm, which were then applied to Carbo Glass Polish (Clear) (t = 2.0mm) manufactured by AGC Inc. After peeling off the protective film, the peel strength was measured when the decorative laminated film was peeled in the 180° direction at a speed of 200.0mm/sec.

(Peelability)

In the evaluation of adhesive strength mentioned above, the peelability of the decorative laminated film was assessed to check if it could be peeled off without any issues.

A: Peeling is possible.
C: Either the adhesive strength is too high to allow peeling, or the adhesive strength is too low, causing it to peel off too easily.

(Ra(C)/Ra(P))

The surface roughness Ra(C) of the decorative laminated film after peeling off the protective film at a speed of 5.0 mm/s, and the surface roughness Ra(P) on the peel side of the protective film were measured. From these values, the ratio [Ra(C)/Ra(P)] × 100 was calculated.
When the value was less than 70, it was difficult to apply the protective film and difficult to impart shape.
When the value was more than 140, the protective film was difficult to peel off, and the surface condition was poor.

(Unevenness Transferability)

The surface of the hard coat layer, which is the outermost layer of the decorative laminated film after peeling off the protective film, was visually observed.

A: Good transferability
C: Poor transferability

(Workability)

The workability of applying the decorative laminated film to a glass monocrystalline silicon cell manually was evaluated.

A: Application can be performed without issues
C: Low adhesive strength makes application impossible, or high adhesive strength makes positioning adjustments difficult.

(Reliability (Moisture and Heat Resistance))

The decorative laminated film was cut into 50 mm × 50 mm pieces and adhered to a glass plate. After peeling off the protective film, it was placed in an environment of 85°C and 85% humidity. After 1500 hours passed, the surface appearance of the hard coat layer, which is the outermost layer, was visually observed.

A: No issues
C: Appearance defects such as cracks present

(Weather Resistance)

Using the Sunshine Weather Meter S80 (Sunshine Carbon Arc Type Accelerated Weathering Test Machine, manufactured by Suga Test Instruments Co., Ltd,), an accelerated weather resistance test was conducted for 1200 hours in accordance with JIS B 7753. The surface of the hard coat layer was irradiated with ultraviolet light, and the color difference was calculated using the following formula (4) based on the hue before the test and the hue after 1200 hours from the start of the test, and was evaluated on the basis of the following criteria.

$$\text{Color Difference} = [(\Delta L^*)2 + (\Delta a^*)2 + (\Delta b^*)2]1/2 \quad (4)$$

In this formula, the symbols indicate the following.
$\Delta L^*$ is the absolute value of the difference between the $L^*$ value before the test and the $L^*$ value after the test.
$\Delta a^*$ is the absolute value of the difference between the $a^*$ value before the test and the $a^*$ value after the test.
$\Delta b^*$ is the absolute value of the difference between the $b^*$ value before the test and the $b^*$ value after the test.

<Evaluation Criteria>

A: The color difference calculated using formula (1) is less than 3.0
C: The color difference calculated using formula (1) is 3.0 or greater

(Peelability of the Protective Film)

A laminated film was obtained by adhering the protective film to the hard coat layer and then performing curing for seven days in a 50°C environment, and the peelability when manually peeling the protective film from the laminated film was evaluated.

A: It can be peeled off without damaging the coating film.
C: During peeling, the coating film undergoes cohesive destruction,
or the protective film is not adhered to the hard coat surface and peels off naturally.

(Dry Film Thickness)

The thickness of the film after applying the paint solution to the support layer and drying it was measured using a constant pressure thickness measuring instrument made by TECLOCK Co., Ltd.

(Surface Free Energy $\gamma$ac and $\gamma$ap)

The decorative laminated film was cut into 50mm $\times$ 50mm pieces. The surface of the decorative laminated film on the protective film side from which the protective film was peeled at a speed of 5.0 mm/s and the surface of the peeled protective film on the decorative laminated film side were measured for the contact angle using an automatic contact angle meter (manufactured by Kyowa Interface Science Co., Ltd., Dmo-701) under conditions of environment of 20°C to 23°C, with a droplet size of 1 $\mu$L and after one second of droplet deposition. The contact angles for DIW (deionized water) and methylene iodide were measured, and the respective surface free energies were calculated using the Owens and Wendt equations. The surface free energy $\gamma$ac of the decorative laminated film on the protective film side from which the protective film was peeled at a speed of 5.0 mm/s was obtained. The surface free energy $\gamma$ap of the protective film peeled at a speed of 5.0 mm/s on the decorative laminated film side was obtained using the same procedure.
From the obtained values of respective surface free energies, $\gamma$ac/$\gamma$ap $\times$ 100 was calculated.

(Martens Hardness HM)

The test sample was cut into 50 mm $\times$ 50 mm pieces and adhered to a glass plate. After peeling off the protective film, the Martens hardness HM (L) of the decorative laminated film was calculated with a Fischer HM2000 microhardness tester, from the indentation depth at maximum load using a Vickers diamond indenter under the conditions of a loading speed of 5 mN/20s and a creep time of 5s.

[Table 4]

| | Example 1 | Example 2 | Example 3 | Example 4 | Example 5 | Example 6 |
|---|---|---|---|---|---|---|
| Protective film | Trefan #40-2500 | Trefan #40-2500 | Trefan #40-2500 | Trefan #40-2500 | KB Film N30 | Trefan #40-2500 |
| Hard coat layer composition | HCA | HCA | HCA | HCA | HCA | HCA |
| Dry film thickness (μm) | 30 | 30 | 30 | 30 | 30 | 30 |
| Drying conditions | 100℃×3min | 100℃×3min | 100℃×3min | 100℃×3min | 100℃×3min | 100℃×1min |
| Decorative layer composition | Decorative A | Decorative B | Decorative C | Decorative A | Decorative A | Decorative A |
| Dry film thickness (μm) | 20 | 20 | 20 | 20 | 20 | 20 |
| Drying conditions | 100℃×3min | 100℃×3min | 100℃×3min | 100℃×3min | 100℃×3min | 100℃×3min |
| Adhesive layer composition | Adhesive A | Adhesive A | Adhesive A | Adhesive A | Adhesive A | Adhesive A |
| Dry film thickness (μm) | 30 | 30 | 30 | 5 | 30 | 30 |
| Total light transmittance [%] | 70 | 90 | 50 | 70 | 70 | 70 |
| Reflectance R [%] | 27 | 5.0 | 40 | 27 | 27 | 27 |
| Refractive index of outermost surface of solar module (Fg) | 1.52 | 1.52 | 1.52 | 1.52 | 1.52 | 1.52 |
| Refractive index of adhesive layer (Fa) | 1.47 | 1.47 | 1.47 | 1.47 | 1.47 | 1.47 |
| \|Fa-Fg\| | 0.05 | 0.05 | 0.05 | 0.05 | 0.05 | 0.05 |
| Adhesive strength[N/25mm] | 25 | 25 | 25 | 1 | 25 | 25 |
| Ra(C)/Ra(P) X100 | 100 | 100 | 100 | 100 | 102 | 100 |
| (γa (C)/γa (P)) ×100 | 98 | 98 | 98 | 98 | 67 | 98 |
| Martens hardness HM | 7.5 | 7.5 | 7.5 | 7.5 | 7.1 | 7.5 |
| Design (reflection color) | A | A | A | A | A | A |
| Output [%] | A | A | A | A | A | A |
| Workability | A | A | A | A | A | A |
| Peelability | A | A | A | A | A | A |
| Moisture and heat resistance | A | A | A | A | A | A |
| Weather resistance | A | A | A | A | A | A |
| Peelability of protective film | A | A | A | A | A | A |
| Unevenness transferability | A | A | A | A | A | A |

[Table 5]

|  | Example 7 | Example 8 | Example 9 | Example 10 |
|---|---|---|---|---|
| Protective film | KB Film N30 | Trefan #40-2500 | Trefan #40-2500 | Trefan #40-2500 |
| Hard coat layer composition | HCA | HCA | HCA | HCF |
| Dry film thickness (μm) | 30 | 30 | 30 | 10 |
| Drying conditions | 100℃×5min | 100℃×3min | 100℃×3min | 100℃×1min |
| Decorative layer composition | Decorative A | Decorative A | Decorative A | Decorative A |
| Dry film thickness (μm) | 20 | 20 | 20 | 20 |
| Drying conditions | 100℃×3min | 100℃×3min | 100℃×3min | 100℃×3min |
| Adhesive layer composition | Adhesive A | Adhesive C | Adhesive D | Adhesive A |
| Dry film thickness (μm) | 30 | 30 | 30 | 30 |
| Total light transmittance [%] | 70 | 65 | 62 | 70 |
| Reflectance R [%] | 27 | 27 | 15 | 27 |
| Refractive index of outermost surface of solar module (Fg) | 1.52 | 1.52 | 1.52 | 1.52 |
| Refractive index of adhesive layer (Fa) | 1.47 | 1.80 | 1.30 | 1.47 |
| \|Fa-Fg\| | 0.05 | 0.28 | 0.22 | 0.05 |
| Adhesive strength[N/25mm] | 25 | 25 | 25 | 25 |
| Ra(C)/Ra(P) ×100 | 70 | 100 | 100 | 100 |
| (γa (C)/γa (P)) ×100 | 67 | 98 | 98 | 101 |
| Martens hardness HM | 7.5 | 7.5 | 7.5 | 15 |
| Design (reflection color) | A | A | A | A |
| Output [%] | A | A | A | A |
| Workability | A | A | A | A |
| Peelability | A | A | A | A |
| Moisture and heat resistance | A | A | A | A |
| Weather resistance | A | A | A | A |
| Peelability of protective film | A | A | A | A |
| Unevenness transferability | A | A | A | A |

[Table 6]

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 | Comparative Example 12 |
|---|---|---|---|---|---|---|---|---|---|---|---|---|
| Protective film | Trefan #40-2500 | Trefan #40-2500 | Trefan #40-2500 | Trefan #40-2500 | Trefan #40-2500 | KB Film N30 | Trefan #40-2500 | Trefan #40-2500 | KB Film N30 | KB Film N30 | Trefan #40-2500 | Trefan #40-2500 |
| Hard coat layer composition | HCA | HCA | HCA | HCA | HCA | HCA | HCA | HCA | HCC | HCD | HCB | HCE |
| Dry film thickness (μm) | 30 | 30 | 30 | 30 | 30 | 30 | 30 | 30 | 30 | 30 | 30 | 30 |
| Drying conditions | 100℃×3min | 100℃×3min | 100℃×3min | 100℃×3min | 100℃×3min | 100℃×10min | 100℃×3min | 100℃×3min | 100℃×3min | 100℃×3min | 100℃×3min | 100℃×3min |
| Decorative layer composition | Decorative D | Decorative E | Decorative F | Decorative A | Decorative A | Decorative D | Decorative D | Decorative D | Decorative A | Decorative A | Decorative A | Decorative D |
| Dry film thickness (μm) | 20 | 20 | 20 | 50 | 20 | 20 | 20 | 20 | 20 | 20 | 20 | 20 |
| Drying conditions | 100℃×3min | 100℃×3min | 100℃×3min | 100℃×3min | 100℃×3min | 100℃×3min | 100℃×3min | 100℃×3min | 100℃×3min | 100℃×3min | 100℃×3min | 100℃×3min |
| Adhesive layer composition | Adhesive A | Adhesive A | Adhesive A | Adhesive A | Adhesive E | Adhesive A | Adhesive B | Adhesive A | Adhesive A | Adhesive A | Adhesive A | Adhesive A |
| Dry film thickness (μm) | 30 | 30 | 30 | 30 | 30 | 30 | 0.5 | 100 | 30 | 30 | 30 | 30 |
| Total light transmittance [%] | 20 | 92 | 90 | 20 | 50 | 20 | 20 | 20 | 70 | 70 | 70 | 20 |
| Reflectance R [%] | 15 | 5.4 | 4.5 | 45 | 10 | 15 | 15 | 15 | measurement unavailable | measurement unavailable | measurement unavailable | 15 |
| Refractive index of outermost surface of solar module (Fg) | 1.52 | 1.52 | 1.52 | 1.52 | 1.52 | 1.52 | 1.52 | 1.52 | 1.52 | 1.52 | 1.52 | 1.52 |
| Refractive index of adhesive layer (Fa) | 1.47 | 1.47 | 1.47 | 1.47 | 1.25 | 1.47 | 1.47 | 1.47 | 1.47 | 1.47 | 1.47 | 1.47 |
| \|Fa·Fg\| | 0.05 | 0.05 | 0.05 | 0.05 | 0.27 | 0.05 | 0.05 | 0.05 | 0.05 | 0.05 | 0.05 | 0.05 |
| Adhesive strength[N/25mm] | 25 | 25 | 25 | 25 | 25 | 25 | 0.5 | 60 | 25 | 25 | 25 | 25 |
| Ra(C)/Ra(P) X100 | 100 | 100 | 100 | 100 | 100 | 40 | 100 | 100 | 220 | 140 | 100 | 100 |
| (γa (C)/γa (P)) ×100 | 98 | 98 | 98 | 98 | 98 | 113 | 98 | 98 | 45 | 99 | 98 | 98 |
| Martens hardness HM | 7.5 | 7.5 | 7.5 | 7.5 | 7.5 | 7.5 | 7.5 | 7.5 | measurement unavailable | 54 | 1.0 | 7.5 |
| Design (reflection color) | A | C | C | A | A | A | A | A | C | C | C | A |
| Output [%] | C | A | A | C | C | C | C | C | A | A | A | C |
| Workability | A | A | A | A | A | A | C | A | A | A | A | A |
| Peelability | A | A | A | A | A | A | C | C | A | A | A | A |
| Moisture and heat resistance | A | A | A | A | A | A | A | A | A | A | A | A |
| Weather resistance | A | A | A | A | A | A | A | A | A | A | A | C |
| Peelability of protective film | A | A | A | A | A | C | A | A | C | C | A | A |
| Unevenness transferability | A | A | A | A | A | C | A | A | C | C | A | A |

Industrial Applicability

The decorative laminated film for solar cell module of the present invention can be used to decorate solar cells.

Reference Signs List

(A):     Protective film
(B):     Hard coat layer
(C):     Decorative layer
(D):     Printing layer
(F):     Adhesive layer
(G):     Support layer
(H):     Transparent filling layer

## Claims

1.  A decorative laminated film for solar cell module comprising:

    a protective film (A);
    a hard coat layer (B);
    a decorative layer (C);
    a support layer (G); and
    an adhesive layer (F),
    wherein a decorative laminated film (L) in a state where the protective film (A) is peeled off from the decorative laminated film for solar cell module, has a total light transmittance Tt of 50% or more and 90% or less for wavelengths of 380 nm to 810 nm, a reflectance R of 5% or more and 40% or less for wavelengths of 380 nm to 1300 nm, and
    wherein a refractive index Fa of the adhesive layer is 1.3 or more and 1.8 or less.

2.  The decorative laminated film for solar cell module according to claim 1,
    wherein a difference |Fa - Fg| between the refractive index Fa of the adhesive layer and the refractive index Fg of the surface of the solar cell module is 0 or more and 0.5 or less.

3.  The decorative laminated film for solar cell module according to claim 1 or 2, which can be peeled off after being adhered to the solar cell module.

4.  The decorative laminated film for solar cell module according to claim 1 or 2,
    wherein the decorative laminated film (L) in the state where the protective film (A) is peeled off from the decorative laminated film for solar cell module, has an adhesive strength with the solar cell module of 1 N/25mm or more and 50 N/25mm or less.

5.  The decorative laminated film for solar cell module according to claim 1 or 2,
    wherein the hard coat layer is a layer formed by a thermosetting coating composition or an active energy ray-curable coating composition.

6.  The decorative laminated film for solar cell module according to claim 1 or 2,
    wherein the surface roughness Ra(C) of the decorative laminated film (L) from which the protective film is peeled off at a speed of 5.0 mm/s and the surface roughness Ra(P) of the peel side of the protective film satisfy the following formula (1):

$$50.0 \leq (Ra(C)/Ra(P)) \times 100 \leq 210.0 \quad (1).$$

7.  The decorative laminated film for solar cell module according to claim 1 or 2,
    wherein surface free energy $\gamma ac$ of the decorative laminated film (L) in the state where the protective film is peeled off, and surface free energy $\gamma ap$ of the peel side of the protective film satisfy the following formula (2):

$$50.0 \leq (\gamma ac/\gamma ap) \times 100 \leq 110.0 \quad (2).$$

8.  The decorative laminated film for solar cell module according to claim 1 or 2,

wherein Martens hardness HM(L) of the decorative laminated film (L) in the state where the protective film is peeled off, satisfies the following formula (3):

$$2.0 \text{ N/mm}^2 \leq HM(L) \leq 50.0 \text{ N/mm}^2 \quad (3).$$

FIG. 1

FIG. 2

FIG. 3

FIG. 4

FIG. 5

## INTERNATIONAL SEARCH REPORT

| International application No. |
|---|
| **PCT/JP2023/030320** |

| A. | CLASSIFICATION OF SUBJECT MATTER |
|---|---|
| | *H01L 31/048*(2014.01)i; *C09D 201/00*(2006.01)i; *C09J 7/38*(2018.01)i |
| | FI: H01L31/04 560; C09J7/38; C09D201/00 |

According to International Patent Classification (IPC) or to both national classification and IPC

| B. | FIELDS SEARCHED |
|---|---|

Minimum documentation searched (classification system followed by classification symbols)

H01L31/04-31/056

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2021-027266 A (TOYOTA MOTOR CORP.) 22 February 2021 (2021-02-22) paragraphs [0010], [0018]-[0044], fig. 1-10 | 1-8 |
| A | JP 2010-201644 A (FUJITSU COMPONENT LTD.) 16 September 2010 (2010-09-16) entire text, all drawings | 1-8 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 September 2023** | **10 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

| | International application No. |
|---|---|
| | **PCT/JP2023/030320** |

| Patent document cited in search report | Publication date (day/month/year) | Patent family member(s) | Publication date (day/month/year) |
|---|---|---|---|
| JP 2021-027266 A | 22 February 2021 | US 2021/0043787 A1 paragraphs [0043]-[0090], fig. 1A-10 | |
| JP 2010-201644 A | 16 September 2010 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013119553 A
- WO 20191220793 A
- JP 2021027364 A
- JP 2021027266 A

**Non-patent literature cited in the description**

- Esmer URS PX98. Nihon Matai Co. Ltd
- Trefan #40-2500. Toray Industrie
- KB Film N30. Kimoto Co., Ltd